(19) Europäisches Patentamt / European Patent Office / Office européen des brevets

(11) **EP 2 320 571 A1**

(12) **EUROPEAN PATENT APPLICATION**
published in accordance with Art. 153(4) EPC

(43) Date of publication:
**11.05.2011 Bulletin 2011/19**

(51) Int Cl.:
*H03M 1/08* (2006.01)     *H03M 3/00* (2006.01)

(21) Application number: **09809847.8**

(22) Date of filing: **21.08.2009**

(86) International application number:
**PCT/JP2009/064632**

(87) International publication number:
**WO 2010/024196 (04.03.2010 Gazette 2010/09)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **25.08.2008 JP 2008214819**

(71) Applicants:
• **Japan Science and Technology Agency**
 **Saitama 332-0012 (JP)**
• **Kyushu University,**
 **National University Corporation**
 **Fukuoka-shi**
 **Fukuoka 812-8581 (JP)**

(72) Inventors:
• **HIRONAKA Satoshi**
 **Fukuoka-shi**
 **Fukuoka 812-8581 (JP)**
• **KOHDA TOHRU**
 **Fukuoka-shi**
 **Fukuoka 812-8581 (JP)**
• **AIHARA Kazuyuki**
 **Narashino-shi**
 **Chiba 275-0026 (JP)**

(74) Representative: **TBK-Patent**
 **Bavariaring 4-6**
 **80336 München (DE)**

(54) **SIGNAL CONVERTER, PARAMETER DECIDING DEVICE, PARAMETER DECIDING METHOD, PROGRAM, AND RECORDING MEDIUM**

(57) A signal converter and the like, which can more accurately and stably realize signal conversion between an analog signal and a digital signal are proposed. In a β-encoder, when a logic value generated by at least a quantizer 7 is 1, a signal generation unit 11 generates a feedback signal from an amplified signal generated by an amplifier 5 and a power source signal generated by a power source 9, and the signal generation unit 11 adds the feedback signal to an input signal. Therefore, for example, the β-encoder having robustness to fluctuation of a quantizer 7 can be realized. Further, the more-stable β-encoder can be realized by a negative β-encoder that generates the feedback signal using a signal obtained by inverting a sign of the amplified signal. Optimum designs of the amplifier 5 and power source 9 can also be realized.

FIG.1

EP 2 320 571 A1

**Description**

TECHNICAL FIELD

The present invention relates to a signal converter, a parameter deciding device, a parameter deciding method, a program, and a recording medium, and particularly relates to a signal converter or the like that outputs a bit sequence in response to an input signal.

BACKGROUND ART

Analog-to-Digital (A/D) conversion is a basic technology behind various technologies. Phases of the A/D conversion consist of sampling and quantization. A sampling theorem guarantees that a signal can be completely reconstructed with a sampled value. The quantization is a process of encoding the sampled value where quantization error inevitably arises.

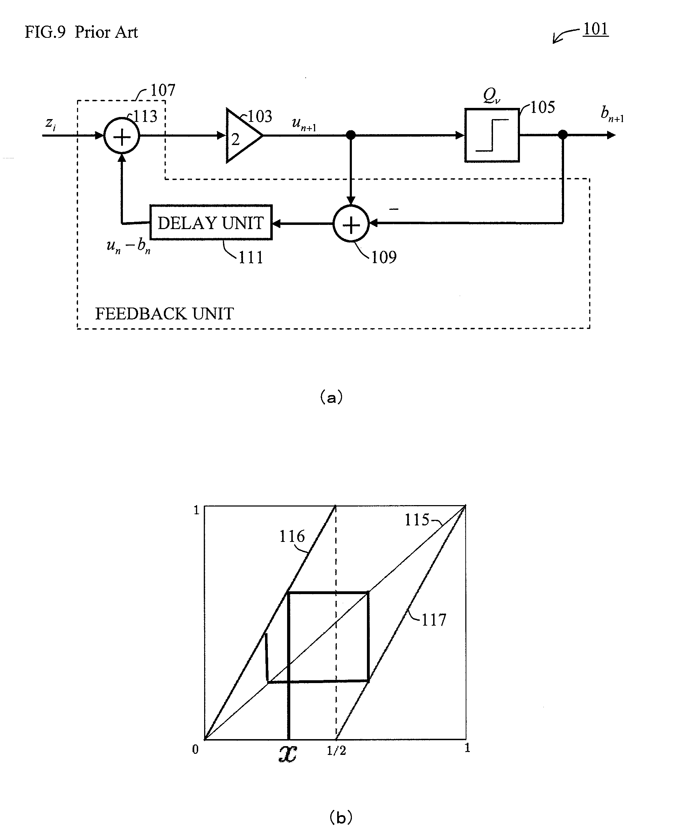

FIG. 9(a) is a block diagram illustrating an outline of PCM (Pulse Code Modulation) and FIG. 9(b) is a view illustrating a map of the PCM. As illustrated in FIG. 9(b), y = x (line 115), a line (line 116) connecting an origin and (1/2, 1), and a line (line 117) connecting (1/2, 0) and (1, 1) are used in the PCM. As illustrated in FIG. 9(b), the PCM realizes the Bernoulli shift map.

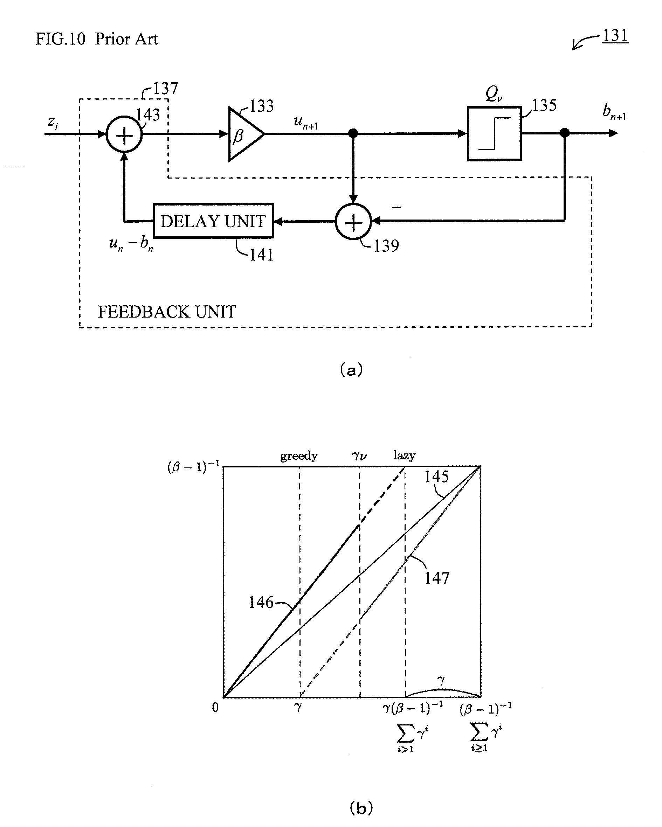

FIG. 10 (a) is a block diagram illustrating an outline of a β-encoder and FIG. 10(b) is a view illustrating a map of the β-encoder. As illustrated in FIG. 10(b), y = x (line 145), as well as a line (line 146) connecting the origin and $(\gamma(\beta-1)^{-1}, 1)$ and a line (line 147) connecting $(\gamma, 0)$ and (1, 1) which are classified by $x = \gamma v$, are used in the β-encoder. The β-encoder is based on β-expansion. I. Daubechies, et al. introduced an A/D converter having robustness to fluctuation of a quantization threshold and that of an amplifier (see Non-Patent Document 1, hereinafter referred to as a "conventional β-encoder").

The inventors further proposed a β-encoder by refining the conventional β-encoder (see Patent Document 1 and Non-Patent Document 2).

PRIOR ART DOCUMENTS

PATENT DOCUMENT

Patent Document 1: PCT/JP2008/62897

NON-PATENT DOCUMENTS

Non-Patent Document 1: I. Daubechies, and three others, "A/D Conversion With Imperfect Quantizers," IEEE Transactions on Information Theory, vol. 52, no. 3, pp. 874-885, Mar. 2006. Non-Patent Document 2: S, Hironaka, and two others, "Markov chain of binary sequences generated by A/D conversion using β encoder", Proc. of 15th IEEE International Workshop on Nonlinear Dynamics of Electronic Systems, pp. 261-264, 2007

SUMMARY OF THE INVENTION

PROBLEM TO BE SOLVED BY THE INVENTION

However, the A/D converter is an analog circuit. A parameter of a circuit component (such as a quantizer or an amplifier) is possibly fluctuated. Therefore, it is necessary to disclose a mathematical structure in consideration of the fluctuation of the circuit component as a practical problem.

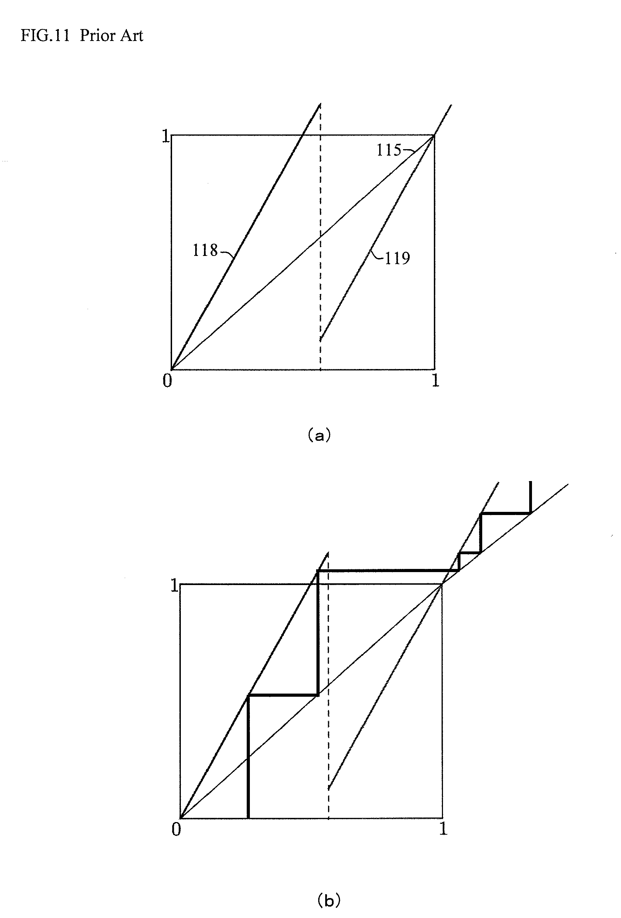

For example, the PCM has high accuracy although it is unstable. FIG. 11 is a view illustrating a case in which a threshold fluctuates in the PCM. When the line 116 and the line 117 of FIG. 9(b) become a line 118 and a line 119 due to the fluctuation of the threshold as illustrated in FIG. 11(a), a map thereof diverges as illustrated in FIG. 11(b). Then, the quantization error does not converge, thereby fails in the A/D conversion. Thus, the PCM does not have the robustness to the fluctuation of the quantization threshold.

The conventional β-encoder is an A/D converter in which the fluctuation of the circuit component is considered. However, a lower limit of an interval is set to a decoded value. Therefore, the quantization error is insufficiently reduced in the conventional β-encoder.

The β-encoder proposed by the inventors is an A/D converter in which the fluctuation of the circuit component is considered similarly to the conventional β-encoder. A middle point of the interval is set to the decoded value, whereby the quantization error is reduced, compared with the conventional β-encoder. However, the β-encoder proposed by the inventors presents only an optimum design guideline for the quantizer, and does not present an optimum design guideline for the amplifier.

In view of the foregoing, it is an object of the present invention to propose a signal converter, a parameter deciding device, a parameter deciding method, a program, and a recording medium that can realize more accurate and stable signal conversion between an analog signal and a digital signal.

MEANS FOR SOLVING THE PROBLEM

A first aspect in accordance with the present invention provides a signal converter that outputs a bit sequence in response to an input signal, the signal converter comprising a feedback unit that generates a composite signal by adding a feedback signal to the input signal, the feedback signal being generated according to a value of the output bit sequence, an amplifier that multiplies the composite signal by $\beta$ ($\beta > 1$) to generate an amplified signal, and a quantizer that quantizes the amplified signal into a logic value 0 or a logic value 1 and thereby outputs a new bit, wherein the feedback unit includes a power source that generates a power source signal, a signal generation unit that generates the feedback signal at least by use of the amplified signal when the logic value 0 is output from the quantizer, and generates the feedback signal by use of the amplified signal and the power source signal when the logic value 1 is output from the quantizer, and an adder that adds the feedback signal to the input signal.

A second aspect in accordance with the present invention provides the signal converter according to the first aspect, wherein the signal generation unit generates the feedback signal by subtracting the amplified signal from the power source signal when the logic value 0 is output from the quantizer, and the signal generation unit generates the feedback signal by subtracting the amplified signal from a signal obtained by $\beta$-multiplying the power source signal when the logic value 1 is output from the quantizer.

A third aspect in accordance with the present invention provides the signal converter according to the first aspect, wherein the signal generation unit generates the feedback signal as being equal to the amplified signal when the logic value 0 is output from the quantizer, and the signal generation unit generates the feedback signal by subtracting a signal obtained by $\beta$-multiplying the power source signal from sum of the amplified signal and the power source signal when the logic value 1 is output from the quantizer.

A fourth aspect in accordance with the present invention provides the signal converter according to any one of the first aspect, the second aspect and the third aspect, wherein a parameter $\beta$ of the amplifier is $2L/(L+1)$ with respect to a number of bits L of the bit sequence output by the signal converter, and/or a parameter s of the power source signal generated by the power source is $\sigma_{\beta,s}(L+1)/2$ with respect to quantiser tolerance $\sigma_{\beta s}$.

A fifth aspect in accordance with the present invention provides a parameter deciding device that decides a parameter in the signal converter as in any one of the first aspect, the second aspect and the third aspect, the parameter deciding device comprising set value storage unit that stores a number of bits L of the bit sequence output by the signal converter and a quantiser tolerance $\sigma_{\beta s}$ of the signal converter, and parameter deciding unit that decides a parameter $\beta$ of the amplifier of the signal converter and a parameter s of the power source signal generated by the power source of the signal converter by = $2L/(L+1)$ and s = $\sigma_{\beta,s}(L+1)/2$, respectively, and correcting $\beta = 2L/(L+1)$ and s = $\sigma_{\beta,s}(L+1)/2$ to $\beta = 2 - 1/\sigma_{\beta,s}$ and s = 1 when the parameter s satisfies s $\leq$ 1.

A sixth aspect in accordance with the present invention provides a parameter deciding method for a parameter deciding device that decides a parameter in the signal converter as in any one of the first aspect, the second aspect and the third aspect, wherein the parameter deciding device includes set value storage unit that stores a number of bits L of the bit sequence output by the signal converter, and parameter deciding unit of the parameter deciding device that decides that a parameter $\beta$ of the amplifier of the signal converter is $2L/(L+1)$.

A seventh aspect in accordance with the present invention provides a parameter deciding method for a parameter deciding device that decides a parameter in the signal converter as in any one of the first aspect, the second aspect and the third aspect, wherein the parameter deciding device includes set value storage unit that stores quantiser tolerance $\sigma_{\beta s}$ of the signal converter, the set value storage unit further stores a number of bits L of the bit sequence output by the signal converter or the parameter $\beta$ of the amplifier of the signal converter, and parameter deciding means of the parameter deciding device decides a parameter s of the power source signal generated by the power source of the signal converter between $\sigma_{\beta,s}(L+1)/2$ and $\sigma_{\beta,s}/(2-\beta)$.

An eighth aspect in accordance with the present invention provides a program that causes a computer to perform the parameter deciding method according to the sixth aspect or the seventh aspect.

A ninth aspect in accordance with the present invention provides a computer-readable recording medium in which the program according to the eighth aspect is recorded.

In each of the aspects, the signal generation unit may generate a feedback signal from an amplified signal and a power source signal when a logic value is 0. Or the signal generation unit may generate the feedback signal from the amplified signal and the power source signal both when the logic value is 0 and when the logic value is 1.

In each of the aspects, the specific examples of the power source are a voltage source or a current source.

And the parameter s indicates, for example, a voltage in a constant voltage source or a current in a constant current source. In the fifth to the tenth aspects, $\sigma_{\beta,s}$ is, for example, a quantiser tolerance of the quantizer. In the signal generation unit, the signal obtained by $\beta$-multiplying the power source signal may be obtained by $\beta$-multiplying the power source signal with use of the same amplifier as the amplifier that $\beta$-multiplies the composite signal.

EFFECT OF THE INVENTION

In the signal converter, the fluctuation from the set value at the designing stage is inevitable in each of the parameter $\beta$ of the amplifier and the threshold $\nu$ of the quantizer at the production stage. Therefore, the control of the fluctuation becomes an issue. In the conventional $\beta$-encoder, the quantiser tolerance is $(\beta-1)^{-1}-1$, which depends only on $\beta$. Therefore, the fluctuation of the threshold cannot freely be set.

In each of the aspects of the present invention, at least when the logic value generated by the quantizer is 1, the signal generation unit of the feedback unit generates the feedback signal from not only the amplified signal but also the power source signal generated by the power source. Particularly, in each of the second aspect and the third aspect of the present invention, when the logic value is 1, the signal generation unit generates the feedback signal by subtracting the amplified signal from the signal that is obtained by $\beta$-multiplying the power source signal (or, vice versa, by subtracting the signal obtained by $\beta$-multiplying the power source signal from the amplified signal). Therefore, the negative $\beta$-encoder and the scaled $\beta$-encoder can be realized, and the scale adjusting function for the scale s can be achieved by the parameter s of the power source signal in the signal converter. Further, the optimum design guideline for the amplifier can be obtained. Particularly, as in the fifth aspect of the present invention and the like, the optimum design of the amplifier can be realized according to the number of bits L (bit budget) of the bit sequence output by the signal converter according to any one of the first to the fourth aspects of the present invention. Further, the optimum design of the power source can be realized according to the quantiser tolerance $\sigma_{\beta s}$.

Further, as in the second aspect of the present invention, the signal generation unit of the feedback unit generates the feedback signal using the signal obtained by multiplying the amplified signal by -1, which allows the negative $\beta$-encoder to be realized. Therefore, more stable A/D conversion can be realized.

BRIEF DESCRIPTION OF THE DRAWINGS

FIG. 1 is a schematic block diagram illustrating an outline of a signal converter 1 according to an embodiment of the present invention.
FIG. 2 illustrates quantization error for a quantization threshold $\nu$ with respect to a steady state when a lower limit of an interval is set to a decoded value, a steady state when a middle point of the interval is set to the decoded value, and a transient state when the middle point of the interval is set to the decoded value.
FIG. 3(a) is a schematic block diagram illustrating a signal converter 21 as an example of a scaled $\beta$-encoder, and FIG. 3(b) is a view illustrating a map of the signal converter 21.
FIG. 4 is a schematic block diagram illustrating an example of a parameter deciding device 81 that decides a parameter.
FIG. 5(a) is a schematic block diagram illustrating an outline of a signal converter 41 as an example of the scaled $\beta$-encoder to which a negative $\beta$-map is introduced, and FIG. 5(b) is a view illustrating a map of the signal converter 41.
FIG. 6 illustrates an invariant subinterval of positive $\beta$-expansion.
FIG. 7 illustrates (A) variance by a $\beta$-encoder to which a D/A conversion method of Daubechies is adopted, (B) variance by a positive $\beta$-encoder, and (C) variance by a negative $\beta$-encoder, with respect to the quantization threshold $\nu$.
FIG. 8 illustrates error between a root of a characteristic equation of $\beta$ and $\beta$ in cases of (A) an characteristic equation $P_{Daub}(\gamma)$ of Daubechies, (B) an characteristic equation $P_\beta(\gamma)$ of the positive $\beta$-encoder, and (C) an characteristic equation $P_{N\beta}(\gamma)$ of the negative $\beta$-encoder.
FIG. 9(a) is a block diagram illustrating an outline of conventional PCM, and FIG. 9(b) illustrates a map of the conventional PCM.
FIG. 10(a) is a block diagram illustrating an outline of a conventional $\beta$-encoder, and FIG. 10(b) illustrates a map of the conventional $\beta$-encoder.
FIG. 11 illustrates a state in which a threshold fluctuates in the PCM of FIG. 9.

MODES FOR CARRYING OUT THE INVENTION

Embodiments of the present invention will be described below with reference the drawings. The present invention is not limited to the following embodiments.

First Embodiment

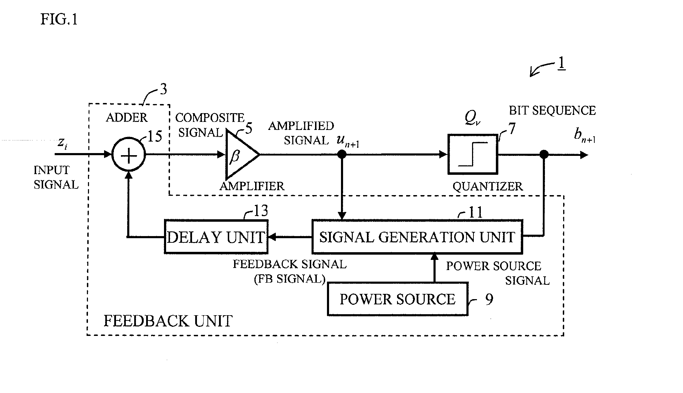

FIG. 1 is a schematic block diagram illustrating an outline of a signal converter 1 according to an embodiment of the present invention. The signal converter 1 outputs a bit sequence $\{b_n\}$ in response to an input signal $z_i$. The input signal $z_i$ is set to a sampled value for $z_0$ and zero for $z_i$ (i > 0). The signal converter 1 performs computation by L-time feedback while $z_i$ is zero (a no-input period), thereby obtaining pieces of L-bit information $b_1$, ..., $b_L$. Hereinafter the number 'i' indicates the time for sampling process, on the contrary, the number 'n' implies the clock time for quantization process using feedback loop.

The signal converter 1 includes a feedback unit 3, an amplifier 5, and a quantizer 7. The feedback unit 3 generates a signal according to a value of generated bit $b_{n+1}$ and adds the signal to the input signal $z_i$ to generate a composite signal. The amplifier 5 generates an amplified signal $U_{n+1}$ by β-multiplying (β > 1) the composite signal generated by the feedback unit 3. The quantizer 7 quantizes the amplified signal $U_{n+1}$ using a quantization function $Q_v$ (x) of a quantization threshold ν expressed by an equation (1) and generates a bit $b_{n+1}$.

[Formula 1]

$$Q_v(x) = \begin{cases} 0, & x < v \\ 1, & x \geq v \end{cases} \qquad (1)$$

The feedback unit 3 includes a power source 9, a signal generation unit 11, a delay unit 13, and an adder 15. The power source 9 generates a power source signal. The signal generation unit 11 generates a feedback signal from at least the amplified signal $U_{n+1}$ in a case of $b_{i+1}$ = 0, and the signal generation unit 11 generates the feedback signal from the amplified signal $U_{n+1}$ and the power source signal in a case of $b_{i+1}$ = 1. The delay unit 13 delays the feedback signal. The adder 15 generates the composite signal by adding the signal delayed by the delay unit 13 to the input signal $z_i$.

The optimum design of the quantizer and a characteristic equation of β will be described. As illustrated in FIG. 10(b), in β-expansion, $[0, (β-1)^{-1}] \rightarrow [0, (β-1)^{-1}]$ is obtained as long as $v \in [1, (β-1)^{-1})$. Therefore, $x = \Sigma∞b_i γ^i$ is obtained to enable A/D conversion. The expansion in a case of ν = 1 is called greedy expansion, and the expansion in a case of $v = (β-1)^{-1}$ is called lazy expansion. When $x \in [1, (β-1)^{-1})$ is β-expanded by L bits, x can be expressed by an equation (2) . In this case, γ = 1/β. An interval I in which x exists is expressed by an equation (3) . The equation (3) indicates that a ratio of a width of a successive (L-1)th subinterval obtained by repetition of β-conversion is equal to γ.

In the conventional β-conversion method, a fixed value $X_{Daub}$ of x is set to a lower limit of the interval as expressed by an equation (4). In this case, a quantiser tolerance is $v γ^L$ as expressed by an equation (5).

On the other hand, the present inventors proposed that a fixed value $X_{L,C}$ of x is set to the middle of the interval as expressed by an equation (6) ("cautious" expansion that is neither the greedy expansion nor the lazy expansion) . In such a case, the quantiser tolerance is $(β-1)^{-1} γ^L /2$ as expressed by an equation (7). In a case of β > 3/2, the tolerance in the equation (7) is improved by 3 dB compared with the tolerance in the equation (5).

A map $N_{β,v}(x)$ stays in an interval [ν-1, ν) through a transient state. The quantization error in this case is expressed by an equation (8).

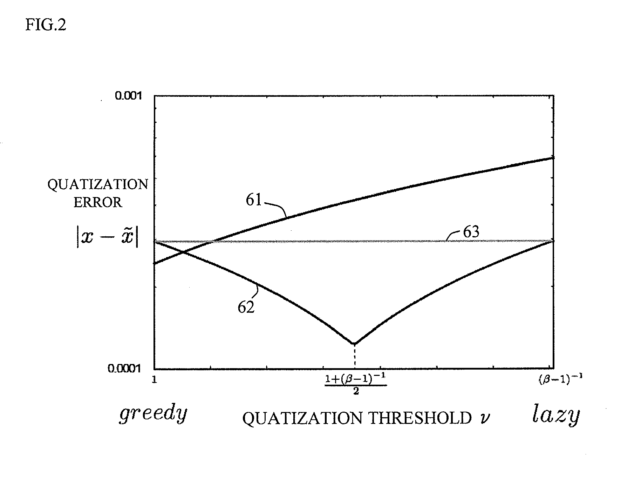

FIG. 2 is a view illustrating the quantization error for the quantization threshold ν in a steady state when the lower limit of the interval is set to the decoded value (line 61), a steady state when the middle point of the interval is set to the decoded value (line 62), and a transient state when the middle point of the interval is set to the decoded value (line 63). Generally, it is recognized that the decoded value of the greedy expansion is better than the decoded value of the lazy expansion. However, as indicated by the line 61, this is caused by use of the fixed value $x_{Daub}$. As can be seen from FIG. 2, the middle point of the interval is effectively used as the decoded value.

The characteristic equation of β of Daubechies is expressed by an equation (9). On the other hand, the characteristic equation of β of the present inventors is expressed by an equation (10). In this case, $b_i$ and $c_i$ (i = 1, ..., L) indicate series of L-bit expansion by the signal converter for x and y (y = 1 - x), respectively.

[Formula 2]

$$x = \sum_{i=1}^{L} b_i \, \gamma^i + \gamma^L N_{\beta,v}^L(x), \quad N_{\beta,v}(x) = \begin{cases} \beta x, & x \in \left[0, \frac{v+1}{\beta}\right) \\ \beta x - 1, & x \in \left[\frac{v+1}{\beta}, \frac{1}{\beta-1}\right) \end{cases} \quad (2)$$

$$I = \left[\sum_{i=1}^{L} b_i \, \gamma^i, \sum_{i=1}^{L} b_i \, \gamma^i + (\beta - 1)^{-1} \gamma^L\right) \quad (3)$$

$$x_{\text{Daub}} = \sum_{i=1}^{L} b_i \, \gamma^i \quad (4)$$

$$\left|x - x_{\text{Daub}}\right| \le v\gamma^L \quad (5)$$

$$x_{L,C} = \sum_{i=1}^{L} b_i \, \gamma^i + \frac{(\beta-1)^{-1}\gamma^L}{2} \quad (6)$$

$$\left|x - x_{L,C}\right| \le \frac{(\beta-1)^{-1}\gamma^L}{2} \quad (7)$$

$$\left|x - x_{L,C}\right| \le \gamma^L \left\{ \left| \upsilon - \frac{(\beta-1)^{-1}+1}{2}\right| + \frac{1}{2} \right\} \quad (8)$$

$$P_{\text{Daub}}(\gamma) = 1 - \sum_{i=1}^{L} (b_i + c_i)\gamma^i = 0 \quad (9)$$

$$P_{\beta}(\gamma) = 1 - \sum_{i=1}^{L} (b_i + c_i)\gamma^i - \frac{\gamma^{L+1}}{(1-\gamma)} = 0 \quad (10)$$

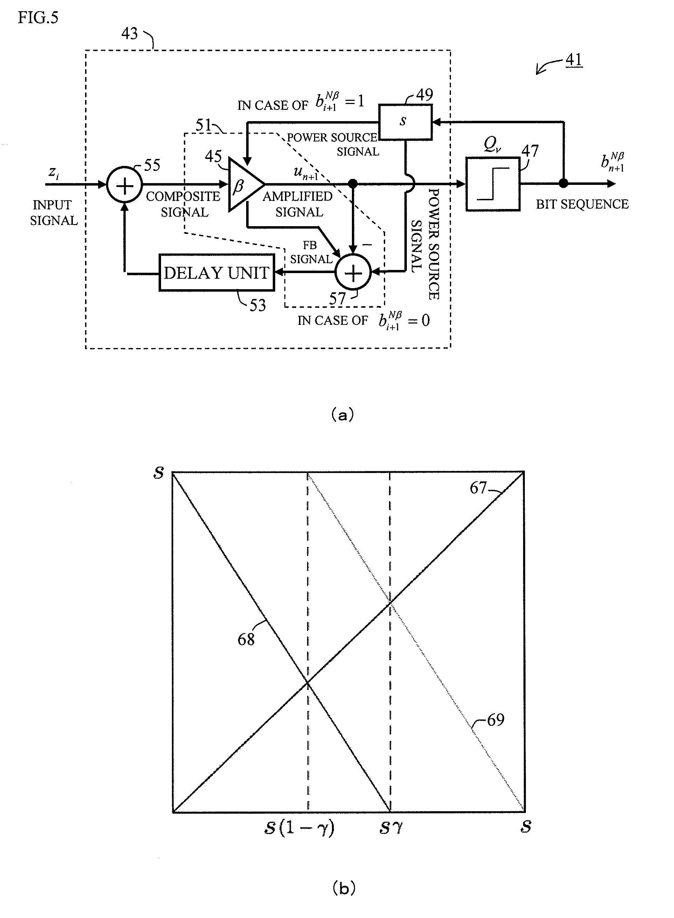

In FIG. 1, the signal generation unit 11 may generate the feedback signal using the signal obtained by multiplying the amplified signal $U_{n+1}$ by -1. As described later with reference to FIG. 5 and other figures, such negative β-encoder realize more stable A/D conversion and D/A conversion.

The power source 9 is a voltage source, a current source, or the like. For example, the power source 9 may be a constant voltage source that generates a constant voltage, a voltage source that can generate different voltages according to time, or a voltage source that generates different voltages according to the value of the generated bit $b_{n+1}$.

The amplifier 5, the quantizer 7, the signal generation unit 11, the delay unit 13, and the adder 15 may partially or entirely be realized by use of a computer.

Second Embodiment

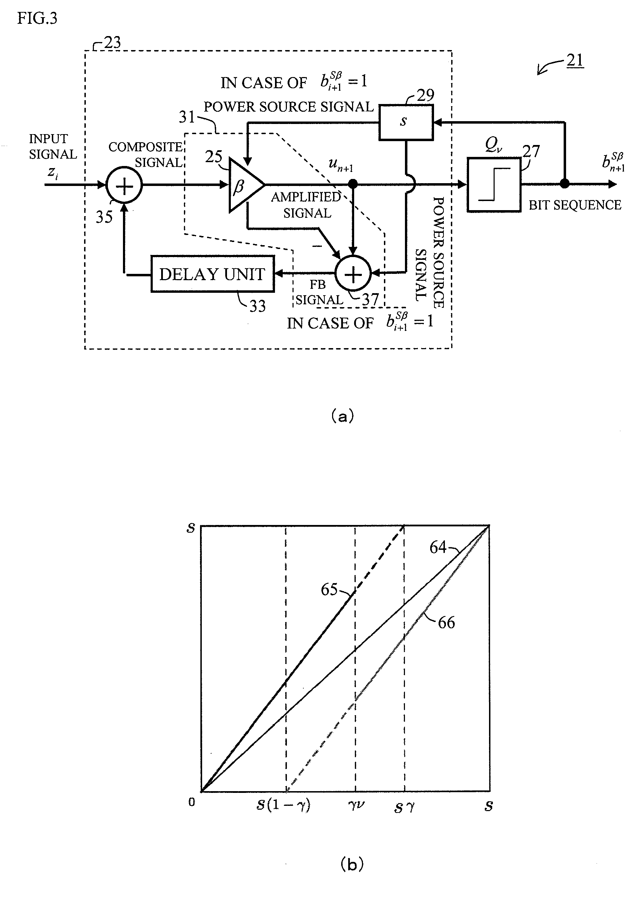

In the present embodiment, a scaled β-encoder (hereinafter referred to as an "S-encoder") will be described. FIG. 3(a) is a schematic block diagram illustrating a signal converter 21 as an example of the S-encoder, and FIG. 3(b) is a view illustrating a map of the signal converter 21. In FIG. 3(a), a feedback unit 23, an amplifier 25, and a quantizer 27 correspond to the feedback unit 3, the amplifier 5, and the quantizer 7 in FIG. 1, respectively. A power source 29, a signal generation unit 31, a delay unit 33, and a first adder 35 of the feedback unit 23 in FIG. 3 (a) correspond to the power source 9, the signal generation unit 11, the delay unit 13, and the adder 15 of the feedback unit 3 in FIG. 1, respectively. The signal generation unit 31 of FIG. 3(a) includes the amplifier 25 and a second adder 37. A power source signal generated by the power source 29 is a bit-control constant power source of the quantizer 27. It is assumed that a parameter (for example, a parameter indicating a voltage in the constant voltage source) of the power source signal is 0 when the generated bit is 0, and it is also assumed that the parameter of the power source signal is s when the generated bit is 1. FIG. 3(a) illustrates the S-encoder of a scale s where s is a scale parameter.

In the signal generation unit 31, when a logic value $b_{i+1}^{S\beta}$ generated by the quantizer 27 is 0, the second adder 37 generates the feedback signal without adding any signal to the amplified signal $U_{n+1}$. When the logic value $b_{i+1}^{S\beta}$ generated by the quantizer 27 is 1, the second adder 37 generates the feedback signal by adding the amplified signal

$U_{n+1}$, the power source signal generated by the power source 29, and the signal which is the power source signal β-multiplied by the amplifier 25.

Conventionally, the stability to the fluctuation of the threshold has been restricted by the parameter β of the amplifier 133 in FIG. 10. More specifically, a quantiser tolerance $\sigma_\beta$ is $\sigma_\beta = |[1, (\beta-1)^{-1}]| = (\beta-1)^{-1} - 1$.

In the present embodiment, for s > 1, a map $S_{\beta,\nu}$ which can perform the A/D conversion in $x \in [0, s)$ is introduced by an equation (11). In this case, $\nu \in [s(\beta-1), s)$. FIG. 3(b) is a view illustrating the map $S_{\beta,\nu}$. The map $S_{\beta,\nu}$ adopts y = x (line 64) and other two lines either of which is used depending on whether the value of x is less than or more than x = γν. The two lines are a line connecting the origin and (sγ, s) (line 65) and a line connecting (s(1-γ), 0) and (s, s) (line 66). In a case of setting $s = (\beta-1)^{-1}$ in an input range [0, s) of the S-encoder, S-encoder is consistent with the β-encoder.

When the sampled value is set to a range of 0 < x < 1, the signal becomes $0 < S_{\beta,\nu}(x) < s$ by the map $S_{\beta,\nu}$ after the negative feedback is applied once. In the signal converter 21, the negative feedback is performed L times where the value after each of the feedbacks falls within the interval (0, s), and the quantizer 27 generates the logic value 0 or 1 every time depending on the magnitude relationship between the value of the order of the generated $\gamma^L$ and ν. As a result, a computation process of the β-expansion can be realized.

The quantiser tolerance is $\sigma_{\beta,\nu} = s(2-\beta)$ in the map $S_{\beta,\nu}$. Therefore, when s is set to $\sigma_{\beta,s}/(2-\beta)$ with respect to the quantiser tolerance $\sigma_{\beta,s}$ (for example, the quantiser tolerance of the quantizer), the stability can be secured by s, and the design can be made according to the quantiser tolerance of the quantizer.

The optimum design of the amplifier 25 will further be described. When $x \in [1, (\beta-1)^{-1})$ is expanded by the S-encoder, x can be expressed by an equation (12). The equation (12) indicates that $S^L_{\beta,\nu,s}(x)$ is obtained by repeating the mapping L times. Because $S^L_{\beta,\nu,s}(x)$ is included in the interval [0, s), an interval $I_{L,\beta,s}$ in which x exists in performing the expansion with the L bits is expressed by an equation (13). Therefore, a width $|I_{L,\beta,s}|$ of the interval is $s\gamma^L$, and the accuracy is improved most when $s\gamma^L$ is minimized. In a case of the tolerance $\sigma_{\beta,s} = a$, $s\gamma^L = \gamma^L a/(2-\beta)$ holds, and an equation (14) is obtained when the width $|I_{L,\beta,s}|$ of the interval is differentiated with respect to β. Therefore, the value of β at which the quantization error is the minimum is expressed by an equation (15). Accordingly, the optimum design of the amplifier can be made according to the bit budget.

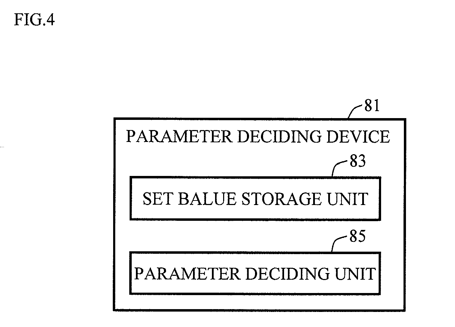

Consequently, either setting s to $\sigma_{\beta,s}/(2-\beta)$ where $\sigma_{\beta,\nu}$ is the quantiser tolerance or setting the parameter β of the amplifier to 2L/(L+1) where L is the bit budget, or both of them may be realized by use of computer. FIG. 4 is a schematic block diagram illustrating an example of a parameter deciding device 81 that decides a parameter. The parameter deciding device 81 includes a set value storage unit 83 and parameter deciding means 85. The quantiser tolerance $\sigma_{\beta,\nu}$ and the bit budget L are stored in the set value storage unit 83. The parameter deciding means 85 sets s to $\sigma_{\beta,s}/(2-\beta)$, that is, $\sigma_{\beta,s}(L+1)/2$, and sets the parameter β of the amplifier to 2L/(L+1).

As described above, in the conventional β-encoder, the logic value is fed back by referring to FIG. 10. The S-encoder of the present embodiment includes the power source 29, and the S-encoder has a plurality of feedback signals. Because the plurality of feedback signals exist in FIG. 3, high-level adjustment is required.

Here, s may be set to 1 and β may be set to $2-1/\sigma_{\beta,s}$ where $\sigma_{\beta,s}$ is the threshold fluctuation, when the fluctuation of the parameter ν of the quantizer 27 can be so suppressed that s < 1 can be realized.

For the L-bit decoded value $x_{L,s}$ of the S-encoder, the maximum error is similar to that of $x_{L,C}$.

[Formula 3]

$$S_{\beta,\upsilon}(x) := \begin{cases} \beta x, & x \in [0, \upsilon\gamma) \\ s - \beta(s-x), & x \in [\upsilon\gamma, s) \end{cases} \qquad (11)$$

$$x = s(\beta-1)\sum_{i=1}^{L} b_i^{S\beta}\gamma^i + \gamma^L S_{\beta,\upsilon,s}^L(x) \qquad (12)$$

$$I_{L,\beta,s}(b_i^{S\beta}) = \left[ s(\beta-1)\sum_{i=1}^{L} b_i^{S\beta}\gamma^i, \, s(\beta-1)\sum_{i=1}^{L} b_i^{S\beta}\gamma^i + s\gamma^L \right) \qquad (13)$$

$$\frac{d\left|I_{L,\beta,s}(b_i^{S\beta})\right|}{d\beta} = \frac{a\beta^{-L-1}}{(2-\beta)^2}\{\beta - L(2-\beta)\} \qquad (14)$$

$$\beta_{opt} = \frac{2L}{L+1} \qquad (15)$$

Third Embodiment

Next in the present embodiment, a scaled β-encoder in which the β-expansion is performed with a negative real number being set as a radix (hereinafter referred to as an "R-encoder") will be described. FIG. 5(a) is a schematic block diagram illustrating an outline of a signal converter 41 as an example of the scaled β-encoder to which a negative β-map is introduced, and FIG. 5(b) is a view illustrating a map of the signal converter 41. In FIG. 5(a), a feedback unit 43, an amplifier 45, and a quantizer 47 correspond to the feedback unit 3, the amplifier 5, and the quantizer 7 in FIG. 1, respectively. A power source 49, a signal generation unit 51, a delay unit 53, and a first adder 55 of the feedback unit 43 in FIG. 5(a) correspond to the power source 9, the signal generation unit 11, the delay unit 13, and the adder 15 of the feedback unit 3 in FIG. 1, respectively. The signal generation unit 51 in FIG. 5(a) includes the amplifier 45 and a second adder 57. A parameter s is of a power source signal. For example, the parameter s indicates a voltage of the power source signal.

In the signal generation unit 51, when a logic value $b_{i+1}$ generated by the quantizer 47 is 0, the second adder 57 generates a feedback signal by adding a signal obtained by multiplying an amplified signal $U_{n+1}$ by -1 and the power source signal s generated by the power source 49. When the logic value $b_{i+1}$ generated by the quantizer 47 is 1, the second adder 57 generates the feedback signal by adding the signal obtained by multiplying the amplified signal $U_{n+1}$ by -1 and a signal obtained by β-multiplying the power source signal s generated by the power source 49 with use of the amplifier 45.

Variance V of the quantization error between a sampled value $x_i$ and a fixed value $x_{L,Ri}$ thereof having a sample number i ($1 \le i \le N$) is defined by an equation (16). Because the middle point of the interval is selected as the fixed value, the variance V is large in a case where ν = 1 (greedy expansion) and in a case where ν = (β-1)$^{-1}$(lazy expansion).

Here, a negative β-map R(x) of the scale s expressed by an equation (17) is introduced. FIG. 5(b) is a view illustrating the map R(x). The map R(x) adopts y = x (line 67), a line (line 68) connecting (0, s) and (sγ, 0), and a line (line 69) connecting (s(1-γ), s) and (s, 0). If s = (β-1)$^{-1}$ for an input range [0, s) of the R-encoder, R-encoder is consistent with the β-encoder.

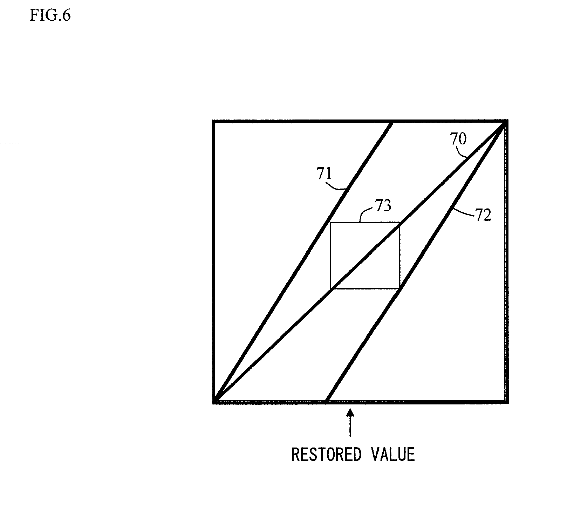

Next, an invariant subinterval is discussed. FIG. 6 is a view illustrating the invariant subinterval of positive β-expansion. In the invariant subinterval of the positive β-expansion, because the middle value is a restored value, average error is large if the invariant subinterval is shifted to an end (for the greedy expansion and the lazy expansion). That is, the invariant subinterval of the β-expansion is [ν-1, ν), and the invariant subinterval [0, 5) is obtained when β= 1, 2. However, the invariant subinterval is only a portion of a width 1 of the subinterval. For example, the bit expansion is performed in the interval [0, 1) for the greedy expansion, in the interval [4, 5) for the lazy expansion, and in the middle subinterval of the interval [0, 5) for cautious. In order to perform normal bit expansion, a transition to the steady state should be made as early as possible. When a sampled value x is uniformly distributed, cautious operated in the middle portion is excellent. Therefore, the invariant subinterval is shifted to the middle portion in an ideal state (see an area 73 in FIG. 6).

Table 1 indicates an invariant subinterval under the map R(x). As indicated in Table 1, the invariant subinterval of the map R(x) is a function of v, and each invariant subinterval is located in the middle of the interval (0, s). The average error for the middle invariant subinterval is substantially equal to that of the positive β-expansion, and the average error is improved because the invariant subinterval is extended in the cases of the greedy expansion and the lazy expansion.

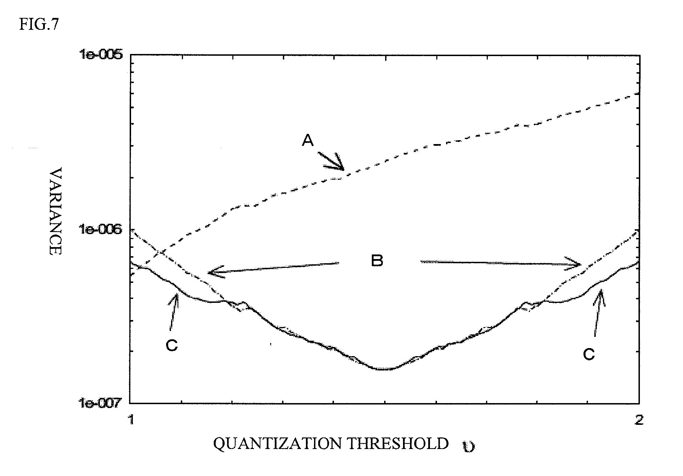

The operation of the signal converter 41 in FIG. 5 (a) will more specifically be described. Set for the sampled value $x \in$ [0, 1] is $b_i^{N\beta} = b_i^{N\beta}(x) \in$ {0, 1}. When x is given, the amplifier 45 sets $u_1 = \beta x$. The quantizer 47 sets $b_1^{N\beta} = 1$ in a case where $u_1 > v$ and sets $b_1^{N\beta} = 0$ in a case where $u_1 \leq v$ (that is, $b_1^{N\beta} = Q_v(u_1)$). When the operation is repeatedly performed for $i \geq 1$, $u_{i+1} = S(b_i^{N\beta}\beta + b_i^{N\beta C}) - u_i$ and $b_{i+1}^{NB} = Q_v(u_{i+1})$ are obtained. In this case, $b_i^{N\beta C} = 1 - b_i^{N\beta}$. An equation (18) holds when $b_i^{N\beta}$ (i = 1, ..., L) is set to binary expansion of R(x) with respect to $x \in$ [0, 1). Because of $R^L(x) \in$ [0, s), the middle point of the interval is selected as the fixed value $x_{L,R}$ of x defined by an equation (19). Therefore, the tolerance for approximation error between the sampled value x and the fixed value $x_{L,R}$ thereof is $s\gamma^L/2$. This is equal to the tolerance of the β-encoder in a case where $s = (\beta-1)^{-1}$ (see FIG. 7). However, the variant of the negative β-encoder is improved in a case where v is set to the neighborhood of the greedy value and the lazy value, even if the fluctuation exists. This is attributed to the fact that, as in the equation (17), the negative feedback needs to be applied in a case where $b_{i+1}$ is equal to 0 or 1, although a feedback amount is varied.

It is assumed that $b_i^{N\beta}$ and $C_i^{N\beta}$ (i = 1, ..., L) are set as the series of L-bit expansion performed with respect to x and y (y = 1 - x) by the R-encoder. When $d_i = b_i^{N\beta} + C_i^{N\beta}$ and $e_i = (1 - b_i^{N\beta}) + (1 - C_i^{N\beta})$ are combined with each other, a characteristic equation of β of the R-encoder is expressed by an equation (20). Estimation of β can be enabled by solving the characteristic equation of β.

FIG. 7 is a view illustrating (A) variance by the β-encoder to which the D/A conversion method of Daubechies is applied, (B) variance by the positive β-encoder, and (C) variance by the negative β-encoder, with respect to the quantization threshold υ. When compared with the (A) β-encoder of Daubechies, the (B) positive β-encoder of the present inventors and the (C) negative β-encoder of the present inventors are largely improved as a whole. The (C) negative β-encoder is substantially equal to the (B) positive β-encoder in the middle portion, and the (C) negative β-encoder is improved for the greedy expansion and the lazy expansion. Thus, the variant of the quantization error of the β-encoder between the sampled value and the fixed value can be improved by the negative β-encoder.

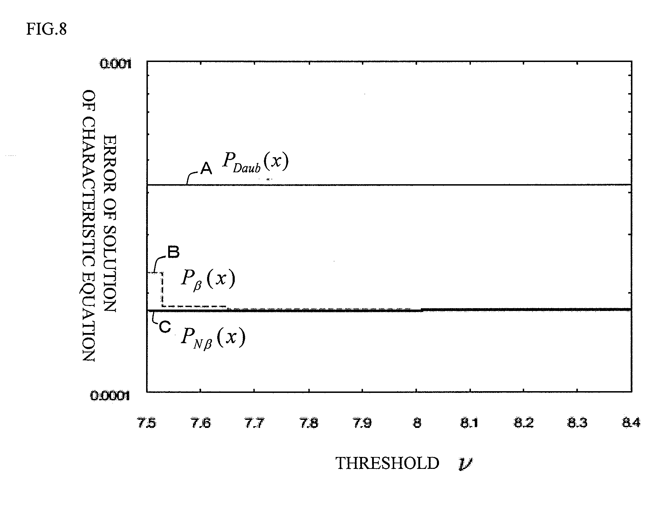

In FIG. 8, a horizontal axis indicates the threshold v and a vertical axis indicates error between a root of the characteristic equation of β and β, in the cases of (A) a characteristic equation $P_{Daub}(\gamma)$ of Daubechies, (B) a characteristic equation $P_\beta(\gamma)$ of the positive β-encoder, and (C) a characteristic equation $P_{N\beta}(\gamma)$ of the negative β-encoder. When compared with (A) $P_{Doub}(\gamma)$, (B) $P_\beta(\gamma)$ and (C) $P_{N\beta}(\gamma)$ are largely improved. (B) $P_\beta(\gamma)$ and (C) $P_{N\beta}(\gamma)$ are substantially equal to each other as a whole.

As described above, the β-expansion in which the negative real number is used as the radix is devised. Besides, the A/D converter and the D/A converter are designed based on the devised β-expansion. Therefore, compared with the conventional β-encoder in which the positive real number is used as the radix, the quantization error is improved, and the instability can be reduced during the mounting of an analog circuit, thereby facilitating the stable circuit mounting.

[Formula 4]

$$V := \frac{1}{N}\sum_{i=1}^{N}\left|x_i - x_{L,R\,i}\right|^2 \tag{16}$$

$$R(x) := \begin{cases} s - \beta x, & x \in [0, v\gamma) \\ \beta s - \beta x, & x \in [v\gamma, s) \end{cases} \qquad \upsilon \in [s(\beta-1), s) \tag{17}$$

$$x = (-\gamma)^L R^L(x) - s\sum_{i=1}^{L}\left(b_i^{N\beta}\beta + b_i^{N\beta C}\right)(-\gamma)^i \tag{18}$$

$$x_{L,R} = s\left[\frac{(-\gamma)^L}{2} - \sum_{i=1}^{L}\left(b_i^{N\beta}\beta + b_i^{N\beta C}\right)(-\gamma)^i\right] \tag{19}$$

$$P_{N\beta}(\gamma) = s\left\{d_1 + \sum_{i=1}^{L-1}\left(d_{i+1} - e_i\right)(-\gamma)^i + \left(1 - e_L\right)(-\gamma)^L\right\} - 1 = 0 \tag{20}$$

[Table 1]

| Threshold ν | Invariant subinterval |
|---|---|
| $(\beta-1)s < v < \dfrac{\beta^2-\beta+1}{\beta+1}s$ | $\left[\beta v - \left(\beta^2-\beta\right)s, \ \beta s - v\right)$ |
| $\dfrac{\beta^2-\beta+1}{\beta+1}s < v < \dfrac{2\beta-1}{\beta+1}s$ | $\left[s-v, \ \beta s - v\right)$ |
| $\dfrac{2\beta-1}{\beta+1}s < v < s$ | $\left[s-v, \ \beta v - \left(\beta-1\right)s\right)$ |

DESCRIPTION OF SYMBOLS

1 signal converter, 3 feedback unit, 5 amplifier, 7 quantizer, 9 power source, 11 signal generation unit, 13 delay unit, 15 adder, 21 signal converter, 23 feedback unit, 25 amplifier, 27 quantizer, 29 power source, 31 signal generation unit, 33 delay unit, 35 first adder, 37 second adder, 41 signal converter, 43 feedback unit, 45 amplifier, 47 quantizer, 49 power source, 51 signal generation unit, 53 delay unit, 55 first adder, 57 second adder

**Claims**

1.  A signal converter that outputs a bit sequence in response to an input signal, the signal converter comprising:

    a feedback unit that generates a composite signal by adding a feedback signal to the input signal, the feedback signal being generated according to a value of the output bit sequence;
    an amplifier that multiplies the composite signal by $\beta$
    ($\beta > 1$) to generate an amplified signal: and
    a quantizer that quantizes the amplified signal into a logic value 0 or a logic value 1 and thereby outputs a new bit, wherein
    the feedback unit includes:
    a power source that generates a power source signal;
    a signal generation unit that generates the feedback signal at least by use of the amplified signal when the logic value 0 is output from the quantizer, and generates the feedback signal by use of the amplified signal and the power source signal when the logic value 1 is output from the quantizer; and
    an adder that adds the feedback signal to the input signal.

2.  The signal converter according to claim 1, wherein
    the signal generation unit generates the feedback signal by subtracting the amplified signal from the power source signal when the logic value 0 is output from the quantizer, and
    the signal generation unit generates the feedback signal by subtracting the amplified signal from a signal obtained by $\beta$-multiplying the power source signal when the logic value 1 is output from the quantizer.

3.  The signal converter according to claim 1, wherein
    the signal generation unit generates the feedback signal as being equal to the amplified signal when the logic value 0 is output from the quantizer, and
    the signal generation unit generates the feedback signal by subtracting a signal obtained by $\beta$-multiplying the power source signal from sum of the amplified signal and the power source signal when the logic value 1 is output from the quantizer.

4. The signal converter according to any one of claims 1 to 3, wherein
a parameter $\beta$ of the amplifier is 2L/(L+1) with respect to a number of bits L of the bit sequence output by the signal converter, and/or
a parameter s of the power source signal generated by the power source is $\sigma_{\beta,s}$ (L+1) /2 with respect to a quantiser tolerance $\sigma_{\beta s}$.

5. A parameter deciding device that decides a parameter in the signal converter as in any one of claims 1 to 3, the parameter deciding device comprising:

    set value storage unit that stores a number of bits L of the bit sequence output by the signal converter and a quantiser tolerance $\sigma_{\beta s}$ of the signal converter; and
    parameter deciding unit that decides a parameter $\beta$ of the amplifier of the signal converter and a parameter s of the power source signal generated by the power source of the signal converter by $\beta$ = 2L/(L+1) and s = $\sigma_{\beta,s}$ (L+1)/2, respectively, and correcting $\beta$ = 2L/(L+1) and s = $\sigma_{\beta,s}$(L+1)/2 to $\beta$ = 2 - 1/$\sigma_{\beta,s}$ and s = 1 when the parameter s satisfies s $\leq$ 1.

6. A parameter deciding method for a parameter deciding device that decides a parameter in the signal converter as in any one of claims 1 to 3, wherein
the parameter deciding device includes set value storage unit that stores a number of bits L of the bit sequence output by the signal converter; and
parameter deciding unit of the parameter deciding device that decides that a parameter $\beta$ of the amplifier of the signal converter is 2L/(L+1).

7. A parameter deciding method for a parameter deciding device that decides a parameter in the signal converter as in any one of claims 1 to 3, wherein
the parameter deciding device includes set value storage unit that stores a quantiser tolerance $\sigma_{\beta s}$ of the signal converter;
the set value storage unit further stores a number of bits L of the bit sequence output by the signal converter or the parameter $\beta$ of the amplifier of the signal converter; and
parameter deciding means of the parameter deciding device decides a parameter s of the power source signal generated by the power source of the signal converter between $\sigma_{\beta,s}$(L+1)/2 and $\sigma_{\beta,s}$/(2-$\beta$).

8. A program that causes a computer to perform the parameter deciding method according to claim 6 or 7.

9. A computer-readable recording medium in which the program according to claim 8 is recorded.

FIG.1

FIG.2

$greedy$    QUATIZATION THRESHOLD $\nu$    $lazy$

FIG.3

IN CASE OF $b_{i+1}^{S\beta}=1$
POWER SOURCE SIGNAL

INPUT SIGNAL $z_i$

COMPOSITE SIGNAL

$\beta$  25

$u_{n+1}$

AMPLIFIED SIGNAL

$s$  29

$Q_\nu$  27

$b_{n+1}^{S\beta}$

BIT SEQUENCE

POWER SOURCE SIGNAL

35

31

DELAY UNIT

33

FB SIGNAL

37

IN CASE OF $b_{i+1}^{S\beta}=1$

23

21

(a)

$s$

65

64

66

$0$  $s(1-\gamma)$  $\gamma\nu$  $s\gamma$  $s$

(b)

FIG.4

PARAMETER DECIDING DEVICE ~81

SET BALUE STORAGE UNIT ~83

PARAMETER DECIDING UNIT ~85

FIG.5

(a)

(b)

FIG.6

RESTORED VALUE

FIG.7

FIG.8

FIG.9  Prior Art

(a)

(b)

FIG.10  Prior Art $\swarrow$ 131

(a)

(b)

FIG.11  Prior Art

(a)

(b)

<table>
<tr><td colspan="2" align="center">**INTERNATIONAL SEARCH REPORT**</td><td>International application No.<br>PCT/JP2009/064632</td></tr>
</table>

A.   CLASSIFICATION OF SUBJECT MATTER
H03M1/08(2006.01)i, H03M3/00(2006.01)i

According to International Patent Classification (IPC) or to both national classification and IPC

B.   FIELDS SEARCHED

Minimum documentation searched (classification system followed by classification symbols)
H03M1/00-1/88, H03M3/00

Documentation searched other than minimum documentation to the extent that such documents are included in the fields searched
Jitsuyo Shinan Koho        1922-1996   Jitsuyo Shinan Toroku Koho    1996-2009
Kokai Jitsuyo Shinan Koho  1971-2009   Toroku Jitsuyo Shinan Koho    1994-2009

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| A | I. Daubechies et al., "A/D Conversion With Imperfect Quantizers", IEEE Trans. on Information Theory, 2006.03, Vol. 52, No. 3, pp. 874-885 | 1-9 |
| P,A | WO 2009/014057 A1 (Japan Science and Technology Agency (et al.)), 29 January 2009 (29.01.2009), entire text; all drawings (Family: none) | 1-9 |
| A | JP 2007-158833 A (Sharp Corp.), 21 June 2007 (21.06.2007), entire text; all drawings (Family: none) | 1-9 |

☐   Further documents are listed in the continuation of Box C.          ☐   See patent family annex.

| | |
|---|---|
| * Special categories of cited documents:<br>"A"  document defining the general state of the art which is not considered    to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>13 October, 2009 (13.10.09) | Date of mailing of the international search report<br>20 October, 2009 (20.10.09) |
|---|---|
| Name and mailing address of the ISA/<br>Japanese Patent Office | Authorized officer |
| Facsimile No. | Telephone No. |

Form PCT/ISA/210 (second sheet) (April 2007)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008062897 W

**Non-patent literature cited in the description**

- **I. Daubechies.** A/D Conversion With Imperfect Quantizers. *IEEE Transactions on Information Theory,* March 2006, vol. 52 (3), 874-885

- **S, Hironaka.** Markov chain of binary sequences generated by A/D conversion using β encoder. *Proc. of 15th IEEE International Workshop on Nonlinear Dynamics of Electronic Systems,* 2007, 261-264